Europäisches Patentamt

(19) European Patent Office

Office européen des brevets

(11) Publication number: **0 014 558**
**B1**

(12) **EUROPEAN PATENT SPECIFICATION**

(45) Date of publication of patent specification: **11.04.84**

(51) Int. Cl.³: **H 01 L 23/40, H 05 K 7/20**

(21) Application number: **80300263.3**

(22) Date of filing: **29.01.80**

(54) Assembly of an electrical component and a heat sink on a printed circuit board and method of assembling.

(30) Priority: **31.01.79 US 8032**
**13.11.79 US 93281**

(43) Date of publication of application:
**20.08.80 Bulletin 80/17**

(45) Publication of the grant of the patent:
**11.04.84 Bulletin 84/15**

(84) Designated Contracting States:
**AT BE CH DE IT NL SE**

(56) References cited:
**FR - A - 2 338 621**
**US - A - 3 859 570**
**US - A - 4 103 737**

(73) Proprietor: **THERMALLOY INCORPORATED**
**2021 West Valley View Lane**
**Dallas Texas (US)**

(72) Inventor: **Jordan, William D.**
**4433, Beverly Drive**
**Dallas Texas (US)**
Inventor: **Hundt, Roger C.**
**2305, Westbrook**
**Carrollton Texas (US)**
Inventor: **Pritchett, James D.**
**3414 Post Oak Road**
**Garland Texas (US)**

(74) Representative: **Arthur, George Fitzgerald et al,**
**KILBURN & STRODE 30, John Street**
**London WC1N 2DD (GB)**

Courier Press, Leamington Spa, England.

Assembly of an electrical component and a heat sink on a
printed circuit board and method of assembling

This invention relates to heat sink mountings and one object is to provide a simple and yet efficient way of mounting on a printed circuit board an electrical component such as a semi-conductor device which generates sufficient heat in use to require to be assembled with a heat sink. A heat sink is merely a body of thermally conductive material for example, copper or aluminium, which may include fins, which is in intimate contact with the heat generating device and which provides a substantial surface area for transmission of heat to the surrounding air.

Printed circuit boards tend to have a number of components assembled with them, and electrically connected to the printed circuit by soldering, and it has been usual to connect up those components which do not generate much heat by a conventional wave soldering operation. Then it has been usual to clean and trim the board and inspect it and then mount semi-conductor devices and the like with their heat sinks in separate manual operations with separate nuts or other connections passing through the circuit board after which the leads from the components are soldered to the printed circuit and cleaning trimming and inspection is repeated.

According to one aspect of the present invention an assembly of an electrical component and a heat sink mounted on a printed circuit board by at least one stud which serves to hold the component assembled with the heat sink is characterised in that the projecting end of the or each stud, which end is suitable for assembly with the printed circuit, passes through a respective aperture provided in the circuit board and is secured to its underside by soldering and that the or each stud has a flange situated between the circuit board and the heat sink serving to prevent the stud being drawn through the heat sink. The securing is conveniently effected by soldering the exposed, projecting end of the stud to the printed circuit, and for this purpose at least that end of the stud can be plated with a suitable soldering metal.

The stud can be a force fit in a corresponding hole in the heat sink, or can be otherwise assembled with it, and then the exposed end of the stud can be used for assembling the component with the heat sink, conveniently by use of threads on the stud and a co-operating nut, while the projecting end of the stud serves to hold the assembly of the heat sink, stud and component to the printed circuit board.

An advantage is that assembly with the board is merely by soldering the exposed end of the stud to the printed circuit and this can be done in the same machine operation as is used for connecting other non-heat generating electrical components to the printed circuit.

The flange on the stud serves to space the heat sink from the printed circuit board and is thus as thick as the desired spacing and with a diameter sufficient merely to engage the facing surfaces of the heat sink and the board. If a large spacing is required there may be a stand-off shank between the flange and the projecting end of the stud which is effectively an elongation of the flange.

According to a second aspect of the invention an elongate stud for securing a heat sink and an electrical component to a printed circuit board is characterised by a projecting end which is plated to render it suitable for connection to the circuit board by soldering and a radial projecting flange intermediate its ends adapted to be situated between the circuit board and the heat sink and to prevent the stud being drawn through the heat sink.

The/or each stud can be force fitted or swaged into the heat sink and may have a flange with a serrated edge for that purpose.

The heat sink and also the board can have corresponding clearance holes through which leads from the component can pass to the printed circuit on the remote side of the board to which they can be assembled by soldering.

The invention also embraces a method of assembling an electrical component and a heat sink on a printed circuit board in which the electrical component and the heat sink are connected together and to the circuit board by at least one elongate stud and which is characterised in that the projecting end of the or each stud is passed through a respective aperture in the circuit board and is then connected to the underside of the board by soldering and that the stud is prevented from being drawn through the heat sink by a radial flange on the stud. The soldering may be effected in an operation used for soldering other electrical components to the circuit board.

Assembly is simple since all the components can be electrically connected and mounted in a single machine controlled soldering operation. Also the component can be replaced quite easily by disconnecting it from the heat sink, and then using a duplicate to replace it.

The invention may be carried into practice in various ways, and two embodiments will be described by way of example with reference to the accompanying drawings; in which

FIGURE 1 is an exploded view of a semi-conductor device case, a heat sink, and a printed circuit board, to which the case and heat sink are to be assembled;

FIGURE 2 is an elevation of one form of mounting stud used in the assembly of FIGURE 1; and

FIGURE 3 is an elevation of an alternative form of mounting stud.

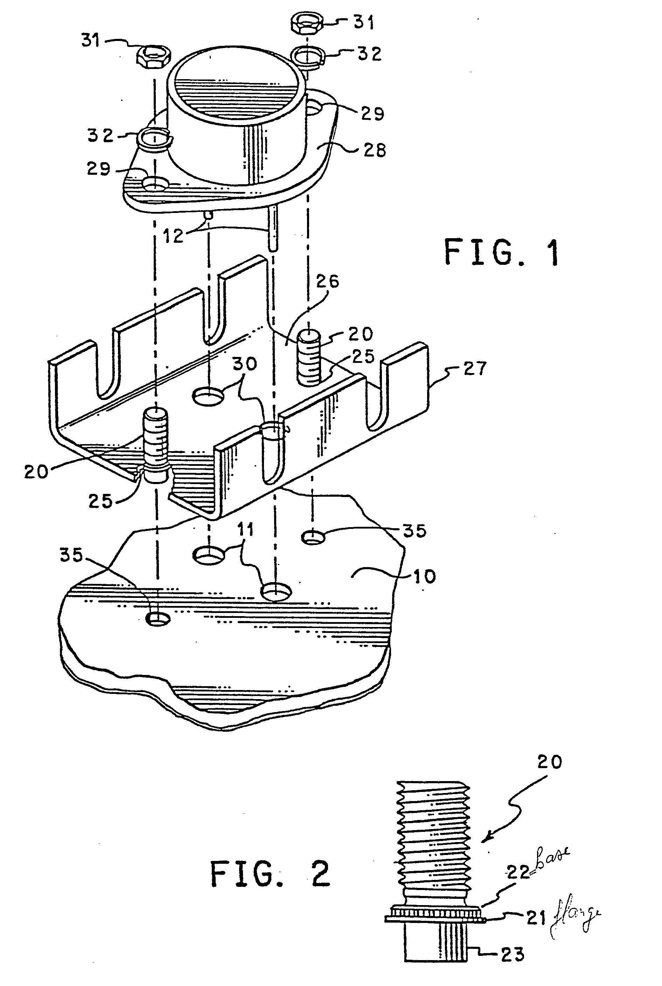

The printed circuit board is of conventional construction comprising a non-conducting layer with a conductive pattern printed on the underside. Various components (not shown) are to be assembled with the board and connected to the pattern on the underside. Some of those components will constitute semi-conductor devices which generate substantial heat in use so that a heat sink is necessary to dissipate some of that heat. One such semi-conductor component is fitted in the case 28 of FIGURE 1 which is a standard TO-3 header and that is to be used with a single broad base heat sink 27. The board 10 has holes 11 for the leads 12 from the semi-conductor device to pass through to the underside of the board where they can be soldered to the conducting layer. There are also a pair of holes 35 for mounting studs 20 shown to a larger scale in FIGURE 2.

The stud of FIGURE 2 comprises a tin plated head 23 which is to be a snug fit in a mounting hole 35 in the circuit board 10. Above the head 23 is a radially extending flange 21 and above that a serrated base 22 which is a tight fit in a mounting hole 25 in the base 26 of the heat sink. The remainder of the stud 20 is in the form of a standard threaded shaft for a lock washer 32 and a nut 31.

First of all two studs 20 have their bases 22 force fitted or swaged into holes 25 in the flat base 26 of the heat sink 27, from underneath, with the flanges 21 abutting the underside of the base. That presumably may be a machine operation. The case 28 is then mounted on the heat sink with the studs 20 passing through clearance holes in a flange on the case, and the lock washers and nuts are fitted and tightened to hold the flange of the case 28 on the base 26 of the heat sink 27. The leads 12 extend through clearance holes 30 in the base of the heat sink.

The complete assembly of heat sink, studs, and semi-conductor case, is then fitted to the board 10 with the leads 12 passing through the clearance holes 11 in the board, and with the stud heads 23 fitting into the holes 35, the end surfaces of the heads 23 being flush with the printed conductive pattern on the underside of the board.

Then in a conventional wave soldering operation in which other non-heat generating components have their leads connected to the printed circuit, the tin plated heads 23 are also soldered to the printed circuit to retain the heat sink and case assembly secured to the printed circuit board. The leads 12 are connected into the printed circuit in the same operation using conventional printed circuit board eyelets (not shown).

It will be appreciated that a single soldering operation is sufficient to connect all the components to the printed circuit, that is to say both the heat generating components which require a heat sink, and the other components which do not. Moreover since the heat sink is held in position on the board by soldering of the stud heads 23 to the printed circuit, it is possible to replace a semi-conductor device without requiring unsoldering and resoldering but merely by removing the nuts 31 and the case 28 and then replacing it with a new semi-conductor device.

The heat sink 27 may be in contact with the upper surface of the printed circuit board 10, or possibly slightly spaced from it by the thickness of the flange 21; whereas it may be desirable to provide a more substantial space between the heat sink base 26 and the upper surface of the printed circuit board to allow for circulation of cooling air.

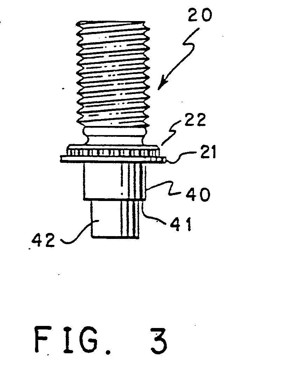

In such an application the studs of FIGURE 3 would be used in preference to those of FIGURE 2. The difference between the two forms of stud is that in the stud of FIGURE 3 there is between the flange 21 and the stud head 42 (23 in FIGURE 2) a stand-off shank 40 with a diameter between those of the flange 21 and the head 42 to define a shoulder 41 which will bear against the upper surface of the printed circuit board 10 to leave a gap with a width equal to the length of the shank 40 and the flange 21 between the board and the heat sink base 26.

Although it has been suggested that only the stud head 23 or 42 is tin plated, because that is the part that is soldered to the printed circuit, it may be convenient to plate the entire stud.

The case could be secured to the studs 20 by use of other mechanical expedients, such as swage clasps rather than the nut and threaded connections described.

The reference to tin plating includes coating with any solder aiding or solder promoting composition such as tin, tin lead alloy, flux and so on.

The advantage of the invention is that the assembly of the semi-conductor device case and the heat sink can be assembled with the printed circuit board by placing in position, and soldering in the same soldering operation used for soldering other electrical components to the printed circuit board. That saves time, avoids difficulties that may arise due to excessive handling of the components, and avoids the need for hand soldering.

**Claims**

1. An assembly of an electrical component (28) and a heat sink (26) mounted on a printed circuit board (10) by at least one stud (20) which serves to hold the component assembled with the heat sink characterised in that the projecting end (23) of the or each stud (20), which end is suitable for assembly with the printed circuit, passes through a respective aperture (35) provided in the circuit board and is secured to its underside by soldering and that the or each stud has a flange (21) situated between the circuit board and the heat sink serving to prevent the stud being drawn through the heat sink.

2. An assembly as claimed in Claim 1 characterised in that the projecting end of the or each stud (20) is plated.

3. An assembly as claimed in Claim 1 or Claim 2 characterised in that the electrical component (28) is held to the heat sink (26) by a releasable device (31).

4. An elongate stud (20) for securing a heat sink (26) and an electrical component (28) to a printed circuit board (10) characterised by a projecting end (23) which is plated to render it suitable for connection to the circuit board (10) by soldering and a radial projecting flange (21) intermediate its ends adapted to be situated between the circuit board and the heat sink and to prevent the stud being drawn through the heat sink.

5. A stud as claimed in Claim 4 characterised by a radially projecting base (22) adjacent the flange (21) and having a lesser radial dimension than the flange adapted to be received in a hole in the heat sink (26).

6. An assembly of a heat sink (26) suitable for carrying an electrical component (28) and an elongate stud (20) as claimed in Claim 4.

7. An assembly of a heat sink (26) suitable for carrying an electrical component (28) and an elongate stud (20) as claimed in Claim 5, characterised in that the heat sink has a hole (25) into which the base of the stud is force fitted or swaged.

8. A method of assembling an electrical component and a heat sink on a printed circuit board in which the electrical component (28) and the heat sink (26) are connected together and to the circuit board (10) by at least one elongate stud (20) characterised in that the projecting end (23) of the or each stud (20) is passed through a respective aperture (35) in the circuit board and is then connected to the underside of the board by soldering and that the stud is prevented from being drawn through the heat sink by a radial flange (21) on the stud.

9. A method as claimed in Claim 8 characterised in that the projecting end (23) is secured to the circuit board (10) in an operation used for soldering other electrical components to the circuit board.

**Revendications**

1. Assemblage d'un composant électrique (28) et d'un refroidisseur (26) monté sur un support à circuit imprimé (10) par au moins un goujon (20) qui sert à maintenir le composant assemblé avec le refroidisseur, caractérisé en ce que l'extrémité saillante du goujon (20) au moins unique qui se prête à un assemblage avec le circuit imprimé traverse une ouverture (35) prévue dans le support à circuit imprimé et est fixé à sa face inférieure par brasage et le goujon comporte une bride (21) qui est située entre le support à circuit imprimé et le refroidisseur et qui sert à empêcher le goujon d'être tiré à travers le refroidisseur.

2. Assemblage suivant la revendication 1, caractérisé en ce que la première extrémité du goujon (20) est étamée.

3. Assemblage suivant la revendication 1 ou 2, caractérisé en ce que le composant électrique (28) est maintenu sur le refroidisseur (26) par un dispositif desserrable (31).

4. Long goujon (21) destiné à fixer un refroidisseur (26) et un composant électrique (28) à un support à circuit imprimé (10), caractérisé par une extrémité saillante (23) qui est étamée de manière à pouvoir être reliée au support à circuit imprimé (10) par brasage et une bride radiale saillante (21) entre ses extrémités propre à être placée entre le support à circuit imprimé et le refroidisseur et à empêcher le goujon d'être tiré au travers du refroidisseur.

5. Goujon suivant la revendication 4, caractérisé par une base (22) en saillie radialement près de la bride (21), cette base ayant une dimension radiale inférieure à celle de la bride mais propre à être reçue dans un trou du refroidisseur (26).

6. Assemblage d'un refroidisseur (26) pouvant supporter un composant électrique (28) et d'un long goujon (20) suivant la revendication 4.

7. Assemblage d'un refroidisseur (26) pouvant supporter un composant électrique (28) et d'un long goujon (20) suivant la revendication 6, caractérisé en ce que le refroidisseur présente un trou (25) dans lequel la base de goujon est ajustée à force ou étampée.

8. Procédé pour assembler un composant électrique et un refroidisseur sur un support à circuit imprimé dans lequel l'ensemble du composant électrique (28) et du refroidisseur (26) est monté sur le support à circuit imprimé (10) par au moins un long goujon (20), caractérisé en ce qu'on fait passer l'extrémité saillante (23) du goujon au moins unique au travers d'une ouverture (35) du support à circuit imprimé et on la fixe ensuite à la face inférieure du support par brasage, le goujon ne pouvant pas être tiré au travers du refroidisseur, lors de la fixation du composant électrique au refroidisseur, à cause d'une bride radiale (21) prévue sur ce goujon.

9. Procédé suivant la revendication 8, caractérisé en ce que la première extrémité (23) est fixée au support à circuit imprimé (10) au cours d'une opération utilisée pour braser d'autres composants électriques au support à circuit imprimé.

**Patentansprüche**

1. Baugruppe aus einem elektrischen Bauelement (28) und einem Kühlkörper (26), die auf einer gedruckten Schaltungsplatte (10) mit wenigstens einem Stehbolzen (20) montiert ist, der dazu dient, das mit dem Kühlkörper zusammengebaute Bauelement zu halten, dadurch gekennzeichnet, daß das überstehende Ende des wenigstens einen Stehbolzens (20), das zum Zusammenbau mit der gedruckten Schaltung geeignet ist, durch eine Öffnung (35), die in der gedruckten Schaltungsplatte vorgesehen ist, hindurchgeht und mit deren Unterseite durch Löten verbunden ist, und daß der Stehbolzen einen Flansch (21) aufweist, der zwischen der Schaltungsplatte und dem Kühlkörper angeordnet ist, um zu verhindern, daß der Stehbolzen durch den Kühlkörper herausziehbar ist.

2. Baugruppe nach Anspruch 1, dadurch gekennzeichnet, daß das eine Ende des Stehbolzens (20) verzinnt ist.

3. Baugruppe nach Anspruch 1 oder Anspruch 2, dadurch gekennzeichnet, daß das elektrische Bauelement (28) mit dem Kühlkörper (26) durch eine lösbare Vorrichtung (31) verbunden ist.

4. Länglicher Stehbolzen (20) zur Befestigung eines Kühlkörpers (26) und eines elektrischen Bauelementes (28) auf einer gedruckten Schaltungsplatte (10), gekennzeichnet durch ein vorstehendes Ende (23), das verzinnt ist, um es für eine Lötverbindung mit der Schaltungsplatte (10) geeignet zu machen, und zwischen seinen Enden ein radial vorspringender Flansch (21) ausgebildet ist, der zwischen der Schaltungsplatte und dem Kühlkörper zu liegen kommt und den Stehbolzen hindert, durch den Kühlkörper herausziehbar zu sein.

5. Stehbolzen nach Anspruch 4, gekennzeichnet durch eine radial vorspringende Basisfläche (22) in der Nähe des Flansches (21), die eine geringere radiale Abmessung hat als der Flansch und die geeignet ist, von einer Bohrung im Kühlkörper (26) aufgenommen zu werden.

6. Baugruppe mit einem Kühlkörper (26), die geeignet ist, ein elektrisches Bauelement (28) und einen länglichen Stehbolzen (20), wie in Anspruch 4 beansprucht, aufzunehmen.

7. Baugruppe mit einem Kühlkörper (26), die geeignet ist, einen länglichen Stehbolzen (20), wie in Anspruch 5 beansprucht, aufzunehmen, dadurch gekennzeichnet, daß der Kühlkörper eine Bohrung (25) aufweist, in die die Basisfläche Stehbolzens kraftschlüssig eingepaßt oder eingezogen ist.

8. Verfahren zum Zusammenbau eines elektrischen Bauelementes und eines Kühlkörpers mit einer gedruckten Schaltungsplatte, in welcher das elektrische Bauelement (28) und der Kühlkörper (26) in einer Baugruppe auf der Schaltungsplatte (10) durch wenigstens einen länglichen Stehbolzen (20) montiert ist, dadurch gekennzeichnet, daß das Vorstehende Ende (23) des wenigsten einen Stehbolzens durch eine Öffnung (35) der Schaltungsplatte hindurchgeführt und hierauf an der Unterseite der Platte durch Löten befestigt wird, und daß der Stehbolzen gegen Herausziehen durch den Kühlkörper durch einen radialen Flansch (21) am Stehbolzen gehindert ist, wenn das elektrische Bauelement (28) auf dem Kühlkörper befestigt wird.

9. Verfahren nach Anspruch 8, dadurch gekennzeichnet, daß das eine Ende (23) mit der Schaltungsplatte (10) in einem Arbeitsgang verbunden wird, der zum Einlöten der anderen elektrischen Bauteile auf der Schaltungsplatte verwendet wird.

FIG. 1

FIG. 2

FIG. 3